# EUROPEAN PATENT APPLICATION

(11) **EP 1 580 802 A1**
(43) Date of publication of application: **28.09.2005**
(21) Application number: 03786328.9
(22) Date of filing: 25.12.2003
(51) Int. Cl.: H01L 21/304

(54) **SLURRY COMPOSITION FOR CHEMICAL MECHANICAL POLISHING, METHOD FOR PLANARIZATION OF SURFACE OF SEMICONDUCTOR ELEMENT USING THE SAME, AND METHOD FOR CONTROLLING SELECTION RATIO OF SLURRY COMPOSITION**

(30) Priority: 31.12.2002 KR 2002087934
(71) Applicant: Sumitomo Mitsubishi Silicon Corporation, Tokyo 105-8634 (JP); Hanyang Hak Won Co., Ltd., Seoul 133-791 (KR)
(72) Inventor: PARK, Jea Gun, 1003-1901, Moojigaemaeul, Seongnam-city, Kyungki-do (KR); PAIK, Un Gyu, Kangnam-gu, Seoul (KR); PARK, Jin Hyung, Ulju-gun, Ulsan-city (KR); KATOH, Takeo, Seongdong-gu, Seoul (KR)
(74) Representative: Albrecht, Thomas
(86) International application number: PCT/JP2003/016813
(87) International publication number: WO 2004/061925

(57) **Abstract**

A method for controlling a selection ratio of a chemical-mechanical-polishing slurry composition for polishing and ablating an oxide layer selectively in relation to a nitride layer, the method includes: a step of confirming a polishing-rate selection ratio of an oxide layer to a nitride layer of a chemical-mechanical-polishing slurry composition which includes ceria polishing particles, a dispersing agent, and an anionic additive, while a concentration of the anionic additive is changed; and a step of adjusting the concentration of the anionic additive to attain a desired selection ratio of the slurry composition, on the basis of the confirmed polishing-rate selection ratio, thereby controlling the selection ratio of the slurry composition.

## Description

### TECHNICAL FIELD

The present invention relates to a chemical-mechanical-polishing slurry composition, and more particularly, relating to a ceria slurry composition having a greater polishing-rate selection ratio of an oxide layer in relation to a nitride layer, a method for planarizing a surface of a semiconductor device by using the same, and a method for controlling the selection ratio of the slurry composition.

This application claims priority on Korean Patent Application No. 10-2002-0087934, the contents of which are incorporated herein by reference.

### BACKGROUND ART

Chemical mechanical polishing (CMP) in which both mechanical processing by using available abrasives between pressurized wafers and polishing pads and chemical etching by way of chemicals in a slurry proceed simultaneously, is one of fields of semiconductor processing technology. This technology has been essential in global planarization technology for manufacturing the below-described semiconductor chips on a submicronic scale since its development by IBM Corporation of the U.S.A. in the late 1980s.

In a CMP process, a wafer is polished with a pad and slurry. A polishing table to which the pad is fixed provides a simple rotational movement, and a head part applies a pressure at a certain level while rotating in a direction opposite to a rotation direction of the polishing table. The wafer is loaded onto the head part with vacuum, and a surface of the wafer comes into contact with the pad by way of the head part and a applied pressure. A slurry of a working fluid flows into minute spaces between the contact surfaces and polishing particles in the slurry, and mechanical ablating action is provided by various projections on the surface of the pad, and at the same time, chemical ablating action is provided by chemical compositions in the slurry. In the CMP process, from upper parts of protrusions on the surface of the wafer, the wafer comes to contact with the pad by a pressure which is applied between the pad and the wafer, and the parts are pressed in a concentrated manner to obtain a relatively high surface-ablating-rate, thereby these protrusions are ablated gradually, as the process proceeds, to attain widespread planarization.

Depending on types of substances to be polished, slurry compositions are roughly classified into slurries for oxide, slurries for metal, and slurries for polysilicon. A slurry for oxide is a slurry used in polishing an interlayer insulation film and a silicon oxide layer (SiO₂ layer) used in an STI (shallow trench isolation) process, and mainly includes abrasive particles, deionized water, pH stabilizers, and surfactants. Among these substances, the abrasive particles act to provide mechanical surface polishing by a pressure from a polishing machine. For this purpose, silica (SiO₂), ceria (CeO₂), alumina (Al₂O₃), and the like are mainly used.

In particular, a ceria slurry has been used widely in polishing a silicon oxide layer in an STI processes, and a silicon nitride layer is used in most cases as a polishing stopper layer. In general, additives may be added to the ceria slurry for the purpose of improving a polishing-rate selection ratio of an oxide layer in relation to a nitride layer. However, in this instance, not only a nitride-layer ablating rate but also an oxide-layer ablating rate is reduced, and the selection ratio is not substantially improved either. Further, abrasives in the ceria slurry are generally larger than those in the silica slurry. These may cause a problem of creating scratches on the surface of the wafer.

On the other hand, in the case in which the polishing-rate selection ratio of the oxide layer in relation to the nitride layer is small, there is a problem in that dishing phenomena occur in which the oxide layer is ablated excessively due to lost patterns of an adjacent nitride layer, thereby resulting in a failure in attaining uniform surface planarization.

### DISCLOSURE OF THE INVENTION

Objects of the present invention are to solve the above-described problems in the prior art, in particular, one object is to provide a chemical-mechanical-polishing slurry composition capable of providing a sufficient oxide-layer ablating rate even when ceria abrasives are used, based on studies on a dependency of a polishing/ablating rate upon concentrations of additives and a size (dimension) of a abrasives, regarding the chemical-mechanical-polishing slurry composition.

Another object of the present invention is to provide a method for planarizing the surface of a semiconductor device by using the slurry composition of the present invention.

The other object of the present invention is to provide a method for controlling a selection ratio of the slurry composition capable of controlling a ablating-rate selection ratio of the slurry composition of the present invention, as intended by an operator.

The slurry composition of the present invention for accomplishing the above objects is a chemical-mechanical-polishing slurry composition which is used for polishing and ablating an oxide layer selectively in relation to a nitride layer, and which includes ceria polishing particles, a dispersing agent and an anionic additive, wherein the anionic additive is added to control a concentration of the anionic additive so that a polishing-rate selection ratio of an oxide layer to a nitride layer is 40 : 1 or greater.

The ceria polishing particles are preferably polycrystalline particles from the point of view of improving the ablating-rate selection ratio. The anionic additive may be, for example, water-soluble polyacrylic acid or water-soluble polycarboxylate. And a concentration of the anionic additive is preferably from 0.1 to 0.6 wt% in relation to a whole percentage of the slurry composition, because this enables to improve the selection ratio.

A method for planarizing a surface of a semiconductor device of the present invention for attaining another object of the present invention includes a step of preparing a semiconductor substrate in which a level difference is formed on a surface thereof and a nitride layer is formed at least on an upper level surface of the level difference, a step of depositing an oxide layer which is for filling the level difference and planarizing the surface of the semiconductor substrate so that a predetermined thickness of the oxide layer can be added to the surface of the nitride layer, and a step of ablating the oxide layer by a chemical-mechanical-polishing process so as to expose the surface of the nitride layer, wherein in the chemical-mechanical-polishing process, a chemical-mechanical-polishing slurry composition is used, and the chemical-mechanical-polishing slurry composition includes ceria polishing particles, a dispersing agent, and an anionic additive, in which the anionic additive is added to control a concentration of the anionic additive so that a polishing-rate selection ratio of an oxide layer to a nitride layer is 40 : 1 or greater.

The level difference may be a trench area formed on the surface of the semiconductor substrate or a mode in which one side is a protrusion and a part contacting therewith is a recessed groove. The oxide layer may be a silicon oxide layer and the nitride layer may be a silicon nitride layer.

The chemical-mechanical-polishing process may further include a step of ablating the oxide layer to attain a predetermined thickness of the oxide layer by a chemical-mechanical-polishing process in which a silica slurry is used, before the surface of the nitride layer is exposed.

A method for controlling a selection ratio of the slurry composition of the present invention for attaining the other object of the present invention is a method for controlling a selection ratio of a chemical-mechanical-polishing slurry composition for polishing and ablating an oxide layer selectively in relation to a nitride layer which includes a step of confirming a polishing-rate selection ratio of an oxide layer to a nitride layer of a chemical-mechanical-polishing slurry composition which includes ceria polishing particles, a dispersing agent, and an anionic additive, while a concentration of the anionic additive is changed, and a step of adjusting the concentration of the anionic additive to attain a desired selection ratio of the slurry composition, on the basis of the confirmed polishing-rate selection ratio, and thereby controlling the selection ratio of the slurry composition.

According to the present invention, since the anionic additive is added to the ceria slurry in a certain controlled range, the polishing-rate selection ratio of the oxide layer to the nitride layer can be improved. And the polishing-rate selection ratio of the slurry composition can be controlled, as desired, by changing the concentration of the additive. Also, according to the present invention, the polishing-rate selection ratio of the oxide layer to the nitride layer can be improved by using a ceria slurry composition in which the polishing particles are polycrystalline particles having a certain size or greater.

### BRIEF DESCRIPTION OF THE DRAWINGS

Fig. 1 through Fig. 3 are process sectional views explaining a method for planarizing a surface of a semiconductor device according to one embodiment of the present invention.
Fig. 4 is a graph showing relationships between ablating velocities of an oxide film and a nitride film and a concentration of an additive in a chemical-mechanical-polishing slurry of one embodiment of the present invention.
Fig. 5 is a graph showing changes in zeta potential of ceria slurries used in the present invention and in the conventional art.
Fig. 6 is a graph showing a relationship between changes in zeta potential and a concentration of an additive at pH of 7.
Fig. 7 is a graph showing effect of additives of the present invention on particle size distributions of aggregated particles.
Fig. 8 is a schematic view illustrating a selective coating of abrasives in a slurry composition of the present invention.
Fig. 9A and Fig. 9B are drawings illustrating possibilities of contacts between a ceria abrasive in slurry composition of the present invention and an oxide film.
Fig. 10A and Fig. 10B are drawings illustrating possibilities of contacts between a ceria abrasive for a slurry composition of the present invention and a nitride film.
Fig. 11A and Fig. 11B are TEM photos (dark mode) of slurry compositions A and B of the present invention.
Fig. 12A and Fig. 12B are TEM photos (light mode) of slurry compositions A and B of the present invention.
Fig. 13 is a graph showing relationships between a ablating rate of an oxide film and a concentration of an additive in slurry compositions A and B of the present invention.
Fig. 14 is a graph showing relationships between a ablating rate of a nitride film and a concentration of an additive in slurry compositions A and B of the present invention.
Fig. 15 is a graph showing relationships between changes in zeta potential and a concentration of an additive in slurry compositions A and B of the present invention.
Fig. 16 is a graph showing relationships between a mean particle size and a concentration of an additive in slurry compositions A and B of the present invention.
Fig. 17 is a schematic graph explaining a method for controlling a selection ratio between an oxide film and a nitride film in a slurry composition of the present invention.
Fig. 18 is a graph showing relationships between measurements of a ablating rate of an oxide layer and a size of abrasive particles for slurry compositions of the present invention.
Fig. 19 is a graph showing relationships between measurements of a ablating rate of a nitride layer and a size of abrasive particles for slurry compositions of the present invention.
Fig. 20 is a drawing showing a modeling of relationships between a ablating rate and a concentration of an additive in a layer to be etched in compliance with a size of abrasive particles of slurry compositions of the present invention.

### BEST MODE FOR CARRYING OUT THE INVENTION

Hereinafter, explanations will be made in detail regarding preferred embodiments of the present invention by referring to the attached drawings. It shall be construed that these embodiments do not restrict the present invention but are merely given as examples of the present invention for imparting to those skilled in the art an easy understanding regarding the concepts of the present invention.

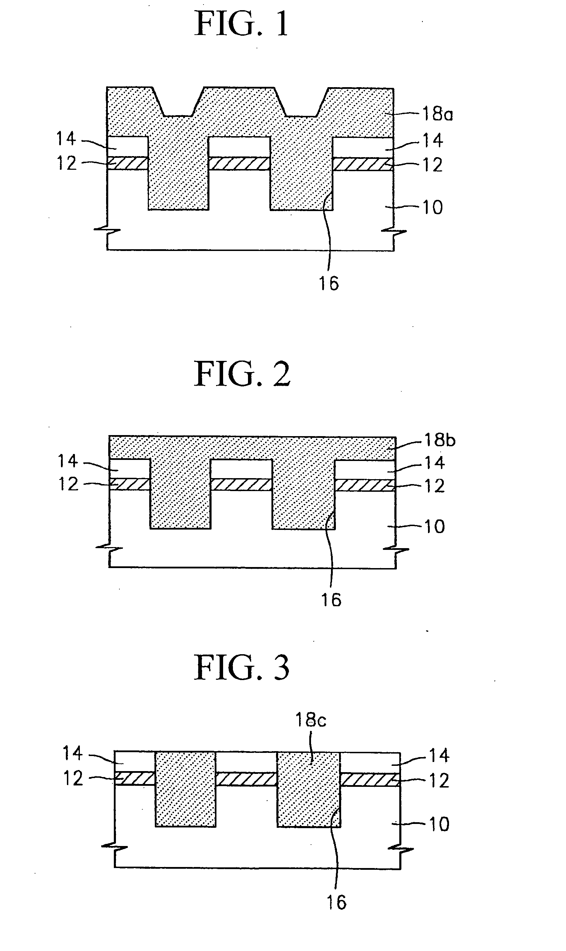

Fig. 1 through Fig. 3 are process sectional views explaining an STI (shallow trench isolation) process which is applied to a method for planarizing a surface of a semiconductor device according to one embodiment of the present invention.

With reference to Fig. 1, for example, a pad layer (12) including silicon oxide (SiO₂) and a nitride layer (14) including silicon nitride (Si₃N₄) are formed on a substrate (10) including silicon monocrystal, and then a photoresist pattern (not illustrated) is formed to define a trench area (16) which provides electrical isolations between device-activating areas. This photoresist pattern is used as an etching mask to etch the nitride layer (14), and is also used as an etching mask to etch the pad layer (12) and the substrate (10) to a predetermined depth, thereby forming the trench area (16). Then, the trench area (16) is subjected to a gap filling, and an oxide layer (18a) including silicon oxide is deposited so that a thickness of the oxide layer from a surface of the nitride layer (14) is a certain height or more.

Then, with reference to Fig. 2, a silica slurry composition is used to perform a primary chemical-mechanical-polishing on the oxide layer (18a). The silica slurry is used because since an abrasive of the silica slurry is in general smaller than that of a ceria slurry, the silica slurry exhibits a high polishing efficiency on the oxide layer (18a) having surface irregularities.

To continue, with reference to Fig. 3, a secondary chemical-mechanical-polishing process is conducted to an oxide layer (18b) remaining on the nitride layer (14) shown in Fig. 2 until the surface of the nitride layer (14) is exposed, so that an oxide layer(18c) is filled only into the trench area (16). The ceria slurry of the present invention is used in the secondary chemical-mechanical-polishing process.

In order to make the nitride layer (14) act as a polishing stopper layer with respect to an oxide layer (18c) in the secondary chemical-mechanical-polishing process, the polishing-rate selection ratio of the oxide layer to the nitride layer must be high. In the case in which the polishing-rate selection ratio of the oxide layer (18c) to the nitride layer (14) is small, dishing phenomena occur in which the oxide layer (18c) is further polished together with the nitride layer (14) in the polishing process, thereby resulting in a failure in attaining a uniform surface planarization.

In the slurry used in an STI CMP process, the ablating-rate selection ratio between the oxide layer and the nitride layer is an important factor to decide an STI process margin and final yield. Comparing with a silica slurry widely used for polishing an oxide layer, a ceria slurry has a large polishing/ablating-rate selection ratio, however scratches are easily occurred in a wafer since a particle size of an abrasive in the ceria slurry is large.

Therefore, the present inventors conducted the following experiments and measurements in which chemical-mechanical-polishing slurry compositions having better polishing/ablating-rate selection ratios of the oxide layer to the nitride layer are prepared and changes in the polishing/ablating-rate selection ratio along with changes in concentrations of additives and particle sizes (dimensions) of abrasives in the slurry compositions are investigated.

First, an 8-inch silicon wafer was prepared. A PETEOS (Plasma Enhanced Tetra-Ethyl-Ortho-Silicate) film was formed as an oxide film by a chemical vapor deposition method, and a nitride film was formed by a low pressure chemical vapor deposition (LPCVD) method, which were prepared to have thicknesses of 7000Å and 1500Å respectively. The oxide film and the nitride film were polished by using a Strasbaugh 6EC which had a single polishing head and a polishing platen. An IC1000/Suba IV pad manufactured by Rodel Inc. was used as the pad. Polishing pressure applied as a down force was set to be 4 psi (pounds per square inch) and a back pressure was set to be 0. Rotation speeds of the head and a table were set to be 70 rpm, and the relative speed between the pad and the wafer was set to be 250 fpm (feet per minute). A slurry flow rate was set to be 100 cm³/min, and a polishing time was set to be 30 seconds. Prior to each polishing process, an ex-situ conditioning was conducted by using a diamond dresser, and film thicknesses before and after the CMP process was measured by using a Nanospec 180 manufactured by Nanometrics Inc.

In order to improve the selection ratio of the ceria slurry as the slurry composition of the present invention, an anionic additive was added to a commercially available ceria slurry. In the present invention, various types of anionic organic additives which include water-soluble polyacrylic acid may be used. In the present embodiment, water-soluble polycarboxylate was used, and a slurry to which the polycarboxylate was added was diluted with deionized water so that a solid loading of a ceria abrasive was 1 wt%. The ceria slurry had a hydrogen ion exponent (pH) of 7.1.

An electrodynamic behavior of a suspension was observed using an ESA-8000 of Metec Applied Science, and zeta potentials on surfaces of a ceria abrasive, the oxide film, and the nitride film were measured using an ELS-800 of Otsuka Electronic Co., Ltd. In addition, photos at high resolution were taken by TEM (transmission electron microscopy) and SEM (scanning electron microscopy), and an X-ray diffraction profile of the abrasive was measured.

From the TEM and SEM photos of the ceria abrasive, the ceria abrasive was observed to be polyhedron, while a fumed silica abrasive was in general spherical. While the fumed silica abrasive which assumes a spherical shape has point contact capability, the ceria abrasive which assumes a polyhedral shape can have plane-contact capability, thereby it enables to accelerate a ablating rate. From the TEM photos, primary particles of the ceria abrasive were observed to have particle sizes of approximately 20 nm to 50 nm, and from the SEM photos, secondary particles of the ceria abrasive were observed to have particle sizes of approximately 400 nm. From a contrast resulting from a Bragg diffraction in the TEM images, the silica abrasive was found to have a non-crystalline structure, whereas the ceria abrasive was found to have a crystalline structure. Further, from the X-ray diffraction profile of the ceria abrasive, the ceria abrasive was found to have a fluorite structure of CeO₂.

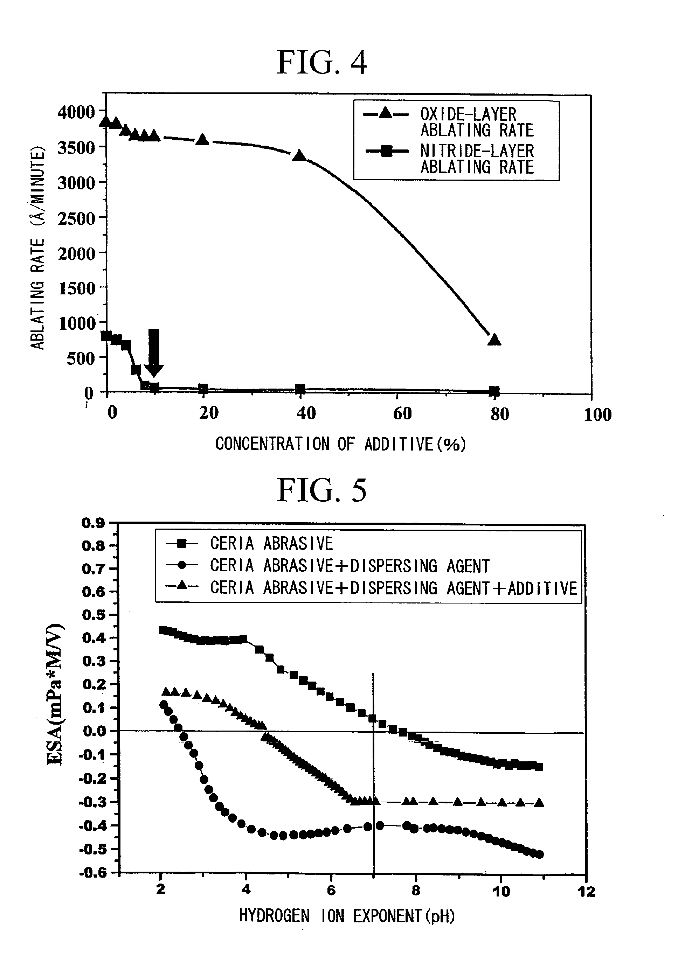

Fig. 4 is a graph showing relationships between ablating velocities of an oxide film and a nitride film and a concentration of an additive in a chemical-mechanical-polishing slurry of one embodiment of the present invention obtained from the measured results.

From Fig. 4, with respect to a ceria slurry which did not include the additive, the ablating-rate selection ratio of the oxide to the nitride was found to be 4 . 8. In contrast , with respect to a silica slurry which was not shown in Fig. 4, the ablating rate of the oxide and that of the nitride were 1879Å/minand467Å/ min respectively, and the selection ratio was 4.0 . From these facts, it is found that when no additive is added, the ceria abrasive cannot make a great contribution to improvement in the selection ratio. Also, when no additive is added, the ablating rate of the ceria slurry is greater than that of the silica slurry. The reason is considered to be due to the fact that the ceria slurry has a plane contact capability and due to a direct chemical reaction involving Ce-O-Si bond between the oxide layer and the ceria abrasive.

It is also confirmed from Fig. 4 that whereas the ablating rate of the oxide layer decreases gradually with the concentration of the additive been increased, the ablating rate of the nitride layer decreases drastically at about 10% of the concentration of the additive (indicated with an arrow). Therefore, it is confirmed that when the concentration of the additive is in a range of 10% (i.e., weight ratio of 0.1) to 60% (i.e., weight ratio of 0.6), the polishing/ablating-rate selection ratio of the oxide layer to the nitride layer is at least 40:1 and favorable.

Fig. 5 is a graph showing changes in zeta potential of the ceria slurries obtained from the measured results. In Fig. 5, the vertical axis shows values of ESA (electrokinetic sonic amplitude) which are measured values of signals closely related to and similar to zeta potential. From Fig. 5, it is confirmed that at pH = 7 which is a value of the hydrogen ion exponent during a chemical-mechanical-polishing process, no great difference in zeta potential of the ceria slurry is indicated, depending on whether the additive is added or not, and further the zeta potential indicates a negative value for the ceria slurry to which the dispersing agent and the anionic additive such as polycarboxylate used in the present invention are added. Therefore, from the aspect of the difference in zeta potential, it is impossible to explain the great difference in the polishing/ablating-rate selection ratio as an effect of the presence or absence of the additive as shown in Fig. 4.

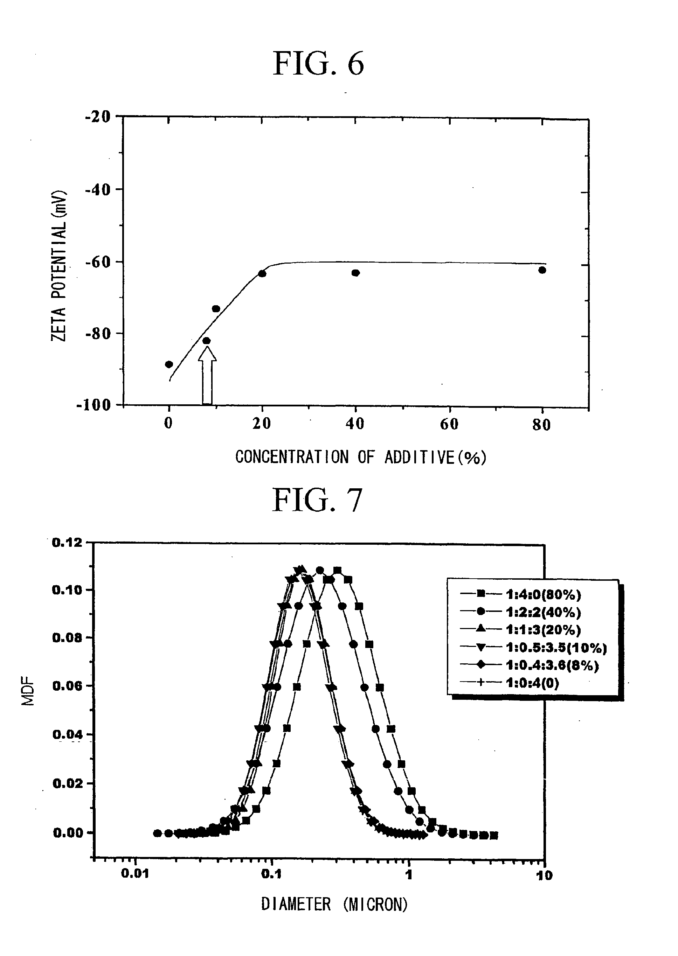

Fig. 6 is a graph showing a relationship between changes in zeta potential and a concentration of an additive at pH of 7. The part shown with an arrow in Fig. 6 corresponds to the part shown with an arrow in Fig. 4, indicating a point where the ablating rate of the nitride layer shows the abrupt change. Zeta potential values of the abrasive in the vicinity of this concentration do not indicate any abruptness or criticaliyt at this point. Therefore, it is impossible to explain the ablating rate of the nitride layer by referring to the zeta potential of the abrasive.

Fig. 7 is a graph showing effect of the additives of the present invention on the particle size distributions of aggregated particles. In Fig. 7, mixture ratios in the slurry compositions indicate the abrasive : the additive : deionized water, and values in parentheses indicate concentrations of the additives (%) . The used additive is water-soluble polyacrylic acid. In this figure, horizontal axis indicates a diameter of the aggregated particles and vertical axis indicates a value of MDF (mean difference fraction) representing the distribution. From Fig. 7, it is confirmed that there is almost no change in particle size of the abrasive when aggregated while the additive is diluted from 20% to 0%. Therefore, from the aspect of the particle size distribution of the abrasive, it is impossible to explain the high selection ratio of the oxide layer to the nitride layer.

The present inventors have measured zeta potential values on surfaces of the ceria abrasive, the oxide film, and the nitride film at pH = 7, the results of which are shown in Table 1.

**Table 1**

| Items | Ceria abrasive | Oxide film | Nitride film |
|---|---|---|---|
| Zeta potential (mV) | about 0 | -40 | +25 |

From Table 1, it is confirmed that the zeta potential on the surface of the ceria abrasive is 0 and the surface of the oxide film has negative value, whereas the surface of the nitride film has positive value. Such difference in zeta potential between the oxide film and the nitride film results in selective coating of an anionic additive onto the film surface. That is, an electrostatic force is generated between the anionic additive and the nitride film having positive values of zeta potential, thereby the additive is coated more favorably onto the surface of the nitride film than onto that of the oxide film.

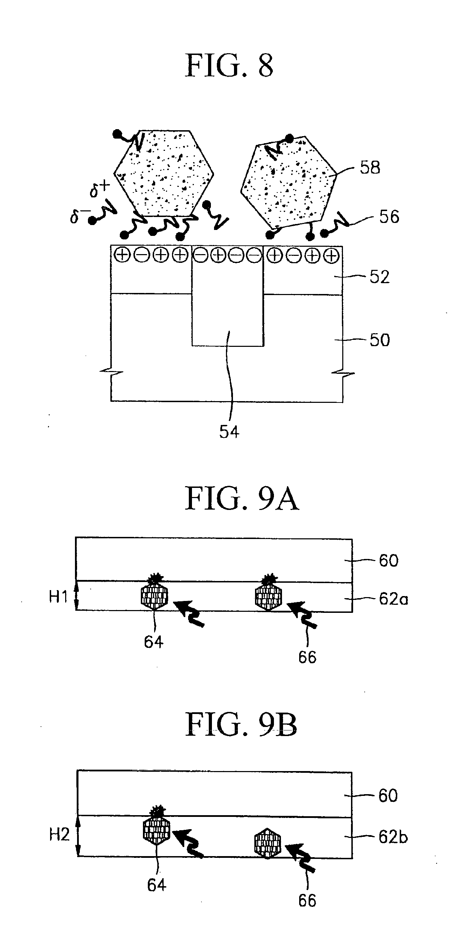

Fig. 8 is a schematic view showing a relationship of the selective coating between the additive and the abrasive in the slurry composition of the present invention.

With reference to Fig. 8, a silicon nitride layer (52) is formed on surfaces of block parts of a substrate (50) having reentrants and salients, and a silicon oxide layer (54) is formed inside a trench area between the block parts. Since values of zeta potential are positive on a surface of the silicon nitride layer (52) as shown in Table 1, an anionic additive (56) is coated more onto the surface of the silicon nitride layer (52) than on a surface of the silicon oxide layer (54). Such selective coating of the anionic additive (56) onto the silicon nitride layer (52) prevents particles of the abrasive (58) from contacting directly the surface of the layer. This phenomenon can cause a great reduction in the polishing/ablating-rate of the nitride layer.

Fig. 9A and Fig. 9B are drawings illustrating possibilities of contacts between a ceria abrasive for the slurry composition of the present invention and an oxide film. In more detail, Fig. 9A shows a case in which a concentration of the additive is relatively low, and Fig. 9B shows a case in which a concentration of the additive is relatively high.

With reference to Fig. 9A and Fig. 9B, a protective layer (62a) having a relatively thin effective thickness "H1" formed by adsorption of a low-concentration anionic additive and a protective layer (62b) having a relatively thick effective thickness "H2" formed by adsorption of a high-concentration anionic additive are formed on surfaces of the oxide layers (60) respectively. In a chemical-mechanical-polishing process, shear stress (66) is applied to the abrasive (64) by a movement of a polishing pad to provide a certain level of dynamic energy. In the case in which such dynamic energy is sufficient to break the protective layers (62a, 62b), the abrasives (64) arrive at the surface of the oxide layers (60) and directly cause a chemical and mechanical reaction with the oxide layers (60). In the case in which the concentration of the additive is relatively low as shown in Fig. 9A, since the effective thickness "H1" is thin, the possibility of contacts between the abrasive (64) and the oxide layer (60) is high, thereby the ablating rate of the oxide layer (60) is increased. In the case in which the concentration of the additive is relatively high as shown in Fig. 9B, since the effective thickness "H2" is thick, the abrasive (64) is less likely to contact the oxide layer (60), thereby the ablating rate of the oxide layer (60) is decreased.

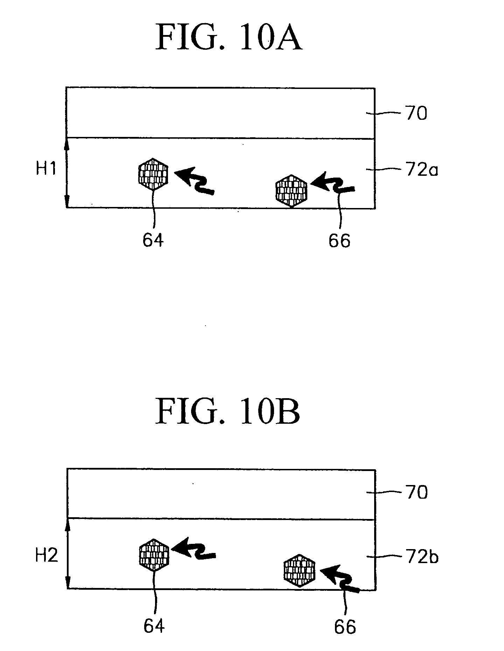

Fig. 10A and Fig.10B are drawings illustrating possibilities of contacts between a ceria abrasive for a slurry composition of the present invention and a nitride film. In more detail, Fig. 10A shows a case in which a concentration of the additive is relatively low, and Fig . 10B shows a case in which a concentration of the is relatively high.

With reference to Fig. 10A and Fig. 10B, a protective layer (72a) having a relatively thin effective thickness "H1" formed by adsorption of a low-concentration anionic additive or a protective layer (72b) having a relatively thick effective thickness "H2" formed by adsorption of a high-concentration anionic additive are formed on surfaces of the nitride layers (70) respectively. As described above, in the chemical-mechanical-polishing process, the shear stress (66) is applied to the abrasive (64) by the movement of the polishing pad. Since the effective thicknesses of the respective protective layers (72a, 72b) formed on the surface of the nitride layers (70) are much greater than those formed on the oxide layers (60), in both cases in which the concentration of the additive is relatively low as shown in Fig. 10A and in which the concentration of the additive is relatively high as shown in Fig. 10B, the abrasives (64) is unlikely to contact with the nitride layers (70), thereby the polishing/ablating-rate of the nitride layer (70) is reduced.

The present inventors have conducted the following experiments and measurements to investigate the effect of a particle size (dimension) of the abrasive on the polishing/ablating-rate selection ratio of the oxide layer to the nitride layer.

First, two types of ceria abrasives were prepared. One was a ceria abrasive formed by using cerium carbonate as a starting material to be subjected to the solid-state displacement reaction method, and a slurry including such ceria abrasive is hereinafter referred to as "slurry A." The other was a ceria abrasive formed by using cerium nitrate as a starting material to be subjected to the wet chemical precipitation method, and a slurry including such ceria abrasive is hereinafter referred to as "slurry B."

In order to investigate an improvement effect in the selection ratio for these two types of slurries, water-soluble polycarboxylate of an anionic additive was added to the slurries, and the slurries were diluted with deionized water so that solid loadings of the ceria abrasives were 1 wt%.

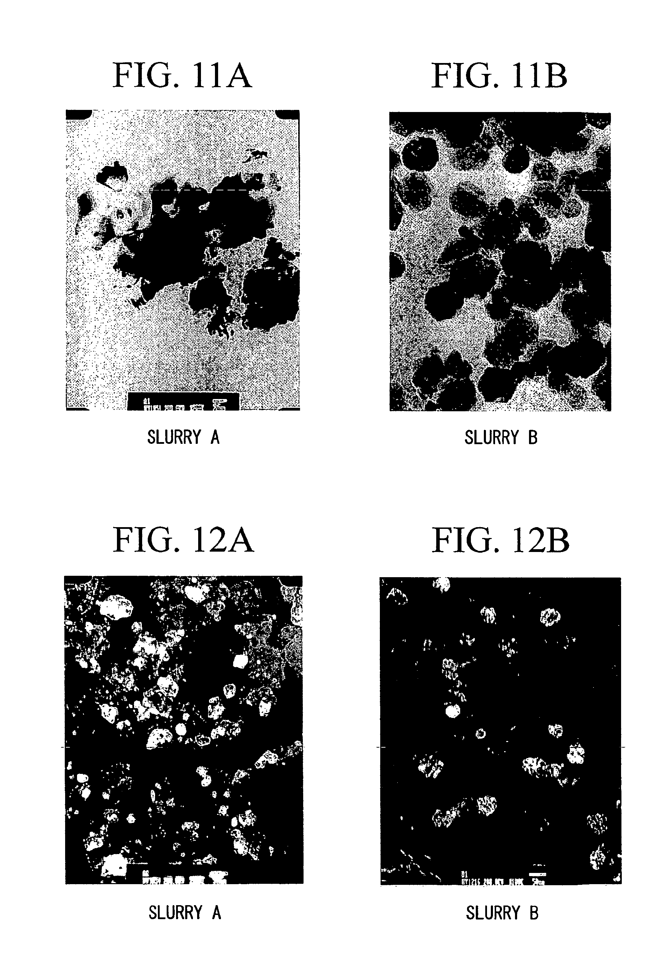

Fig. 11A and Fig. 11B are TEM photos (bright field) of slurry compositions A and B of the present invention. From Fig. 11A and Fig. 11B, it is confirmed that slurry B includes aggregation of mono-crystalline particles of which sizes are from 40 to 60 nm and slurry A includes polycrystalline particles of which grain boundaries are 100 nm or larger.

Fig. 12A and Fig. 12B are TEM photos (dark field) of slurry compositions A and B of the present invention. From Fig. 12A and Fig. 12B, it is confirmed that particles in slurry B have irregular crystal orientations, whereas the polycrystals of the abrasive in slurry A have small grain boundary angles. From these results, it is thought that the abrasives in slurry B become smaller in particle size than those in slurry A by the shear stress applied in the polishing process.

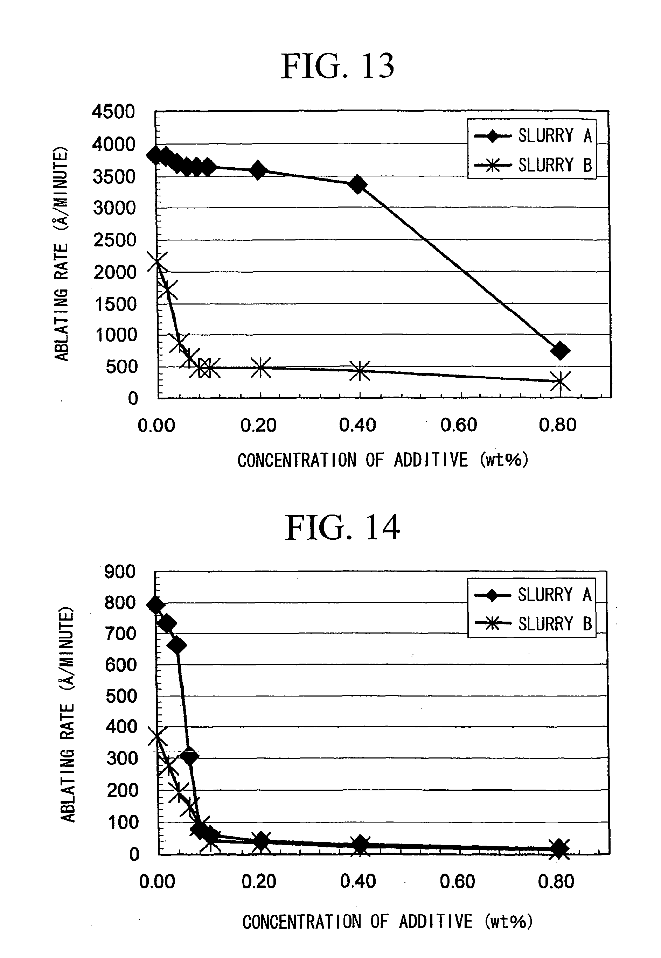

Fig. 13 is a graph showing relationships between a ablating rate of an oxide film and a concentration of an additive in slurry compositions A and B of the present invention. From Fig. 13, it is confirmed that in the case in which no additive is added, the oxide-film ablating rate of slurry B is only approximately half that of slurry A. Also, it is confirmed that the ablating rate of slurry A is decreased very little until the concentration of the additive reaches 0.40 wt% in slurry A, but the ablating rate of slurry B is rapidly decreased when the concentration reaches around 0.08 wt%. Therefore, it is thought that the particle size exerts a great influence on the selection ratio.

Fig. 14 is a graph showing relationships between a ablating rate of a nitride film and a concentration of an additive in slurry compositions A and B of the present invention. From Fig. 14, it is confirmed that in the case in which no additive is added, both in slurry A and in slurry B, the ablating-rate ratios of the oxide layers to the nitride layers are 5 : 1, which are the same as that of a typical silica slurry, however when the concentrations of the additives are increased, both in slurry A and in slurry B, the ablating velocities of the nitride layers are decreased rapidly and substantially plateau at approximately 0.10 wt%.

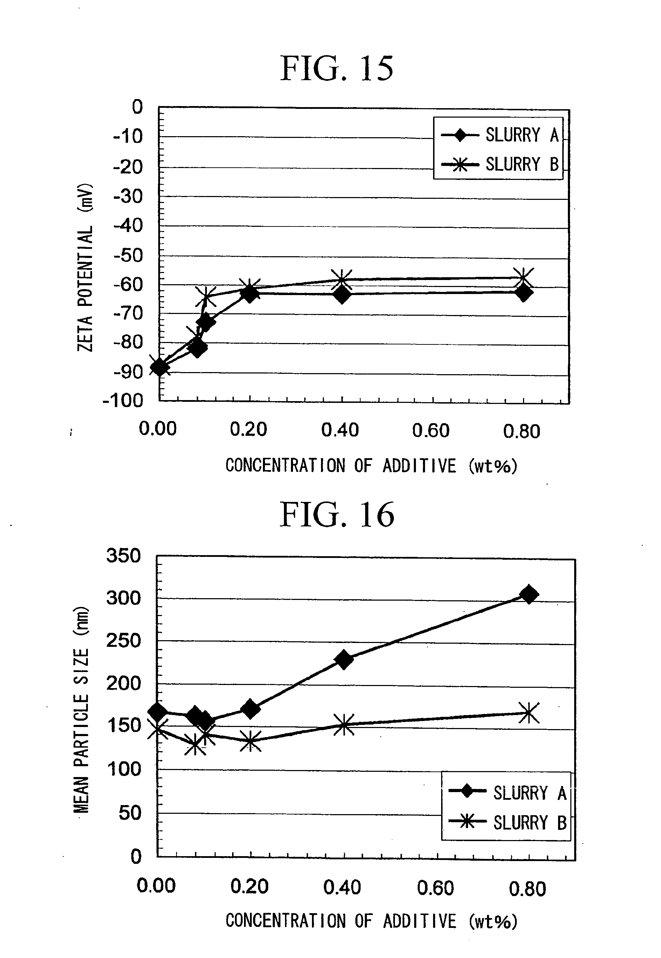

Fig. 15 is a graph showing relationships between changes in zeta potential and a concentration of an additive in slurry compositions A and B of the present invention. From Fig. 15, it is confirmed that both slurry A and B are substantially free of a difference in zeta potential at any concentration of the additive added in the experiment. Since zeta potential on a film surface is independent of particle properties, the electrostatic interactions between particles and the film surfaces are considered to be substantially the same in slurry A and in slurry B. Therefore, from the aspect of such electrostatic interaction, it is thought to be impossible to fully explain the difference in the ablating rate between slurry A and slurry B.

Fig. 16 is a graph showing relationships between a mean particle size and a concentration of the additive in slurry compositions A and B of the present invention. From Fig. 16, it is confirmed that with regard to slurry B, measured particle sizes are from approximately 130 to 170 nm, which is not greatly varied in a whole concentration range of the additive added in the experiment. However, it is confirmed that with regard to slurry A, particle sizes increases from 150 nm to 300 nm with an increase in the concentration of the additive. From comparison of Fig. 11A with Fig. 11B, it is confirmed that abrasives are aggregated to some extent in the slurries, and abrasives in slurry B are thought to be broken into smaller particles than those in slurry A during the polishing process.

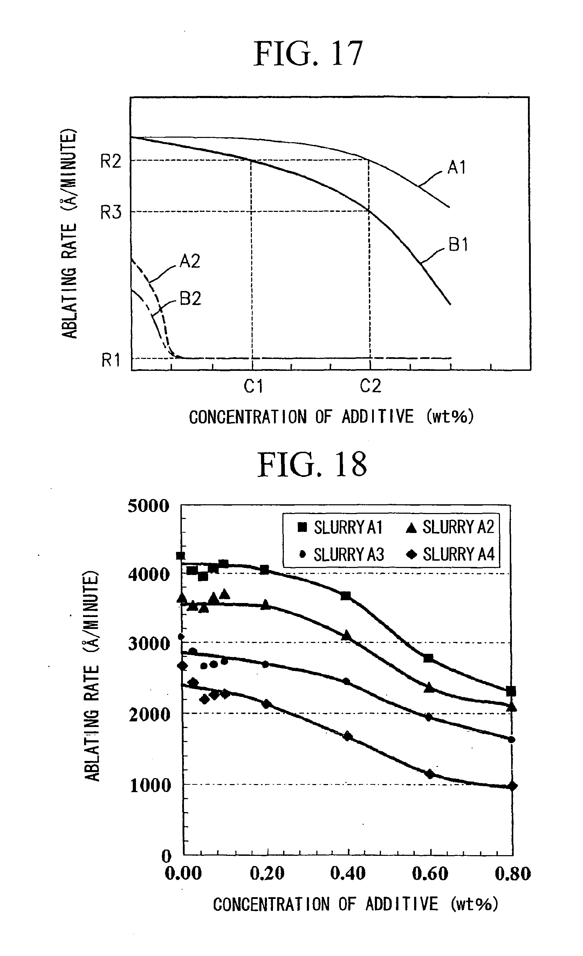

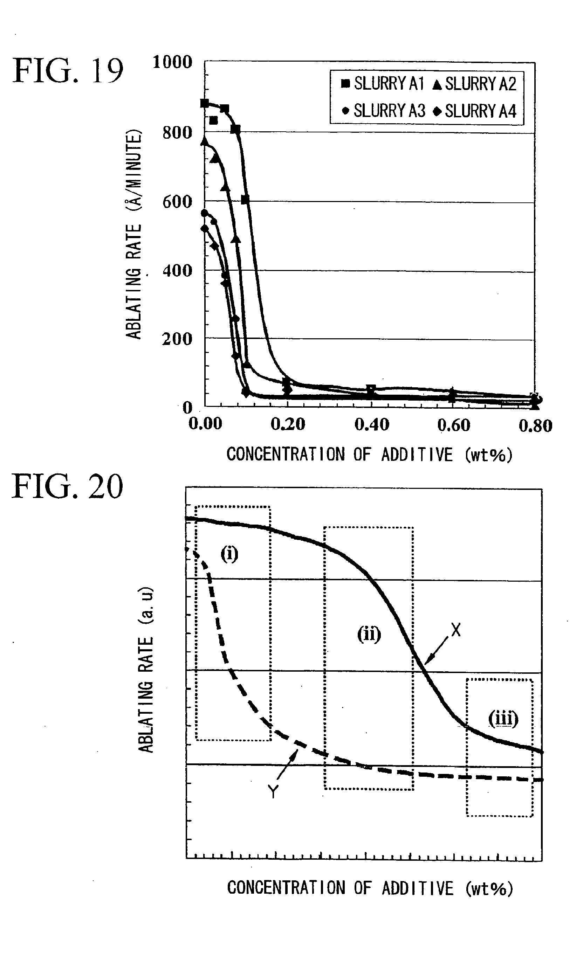

Fig. 18 is a graph showing relationships between measurements of a ablating rate of an oxide layer and a concentration of abrasives, with respect to four types of the slurry compositions, A1, A2, A3, and A4 in which particle sizes of the abrasives are mutually different. Fig. 19 is a graph showing measurements of the ablating rate of the nitride layer.

A ceria abrasive formed by using cerium carbonate as a starting material to be subjected to the solid-state displacement reaction method is used in all slurry compositions A1, A2, A3, and A4. Particle sizes of the abrasive are approximately 290 nm for slurry A1, approximately 148 nm for slurry A2, approximately 81.5 nm for slurry A3 and approximately 71.7 nm for slurry A4. The particle sizes of the abrasive can be controlled by the milling time of a mechanical milling process.

Poly-metha-acrylic ammonium salt was added as a dispersing agent to attain a stable dispersion of the abrasives, and polyacrylic acidwas added as an anionic organic additive at various concentrations of 0, 0.025 , 0.05 , 0.075 , 0.1, 0.2 , 0.4 , 0.6, and 0.8 wt%. Further, the resultants were diluted with deionized water so that solid loadings of the ceria abrasive were 1 wt%, and pH of the slurries were adjusted to 7.

From Fig. 18, it is confirmed that the ablating rate of the oxide layer decreases with a decrease in particle size of the abrasive. Further it is confirmed that a proportion of a decrease in the ablating rate to an increase in the concentration of the additive becomes larger as the particle size of the abrasive is smaller. From Fig. 19, it is also confirmed that the ablating rate of the nitride layer decreases with a decrease in particle size of the abrasive. Further it is confirmed that a proportion of a decrease in the ablating rate to an increase in the concentration of the additive becomes larger as the particle size of the abrasive is smaller. Also, from comparison of Fig. 18 with Fig. 19, it is confirmed that when no additive is added, the ablating rate selection ratio of the oxide layer to the nitride layer is approximately 5 : 1, however the ratio increases to approximately 70 : 1 with an increase in the concentration of the additive.

Fig. 20 is a drawing showing a modeling of relationships between a ablating rate and a concentration of an additive in compliance with a slurry including the abrasive with a relatively large particle size and a slurry including the abrasive with a relatively small particle size. In this drawing, X indicates a case in which the abrasive with a relatively large particle size is used and Y indicates a case in which the abrasive with a relatively small particle size is used. At an area (i) in which the concentration of the additive is relatively low, since a protective layer formed by the additive adsorbed on a surface of a layer to be polished is thin in thickness, both the abrasive with a large particle size and that with a small particle size can easily reach the surface of the layer, thereby a greater ablating rate is obtained. At an area (ii) in which the concentration of the additive is relatively medium, the protective layer is medium in thickness, and the abrasive with a large particle size can easily reach the surface, however the abrasive with a small particle size cannot easily reach the surface. Therefore, in the case in which the abrasive with a large particle size is used, the ablating rate is increased, however, in the case in which the abrasive with a small particle size is used, the ablating rate is significantly decreased. At an area (iii) in which the additive is relatively high in concentration, since the protective layer is very thick, for both the abrasive with a small particle size and the abrasive with a large particle size, it is difficult to reach the surface of the layer to be polished, thereby all the ablating velocities are assumed to decrease.

From the above findings, it is confirmed that in the case in which an additive for controlling the ablating-rate selection ratio of an oxide layer in relation to a nitride layer is not added to a slurry, both the abrasive with a large particle size and that with a small particle size make a direct contact with the surface of the oxide layer and that of the nitride layer, by which the surfaces are polished and ablated. However, amount of the additive adsorbed on the surface of a film increases with an increase in the concentration of the additive, and in this instance, the abrasive with a small particle size has more difficulty in reaching the surface than does that with a large particle size. Further, in the case in which the concentration of the additive is constant, since adsorption amount on the nitride film is larger than that on the oxide film, even the abrasive with a large particle size has difficulty in reaching the surface of the film.

From the above results, an operator is able to use slurry compositions of the present invention after controlling the polishing/ablating rate selection ratio of the oxide layer to the nitride layer to be under optimal conditions as desired.

Fig. 17 is a schematic graph explaining a method for controlling the selection ratio between the oxide film and the nitride film for slurry compositions of the present invention. In Fig. 17, Al indicates a change in polishing/ablating rate of the oxide film layer based on the change in concentration of the additive in a case of a standard slurry, and B1 indicates a change in polishing/ablating rate of the oxide layer in a case of a comparative slurry to be used by an operator. Further, A2 indicates a change in polishing/ablating rate of the nitride layer in a case of the standard slurry, and B2 indicates a change in polishing/ablating rate of the nitride layer in a case of the comparative slurry.

In Fig. 17, the polishing/ablating-rate selection ratio of the oxide layer to the nitride layer means a ratio of the ablating rate of the oxide layer to that of the nitride layer at the same concentration of the additive. Therefore, when the concentration of the additive is C2, the selection ratio of the standard slurry is R2/R1 and that of the comparative slurry is R3/R1. In this instance, when an operator desires to obtain the same selection ratio as in the above standard slurry by using the comparative slurry, the concentration of the additive in the comparative slurry is controlled to change from C2 to C1, thereby the same selection ratio can be obtained. Such a method makes it possible to easily control the selection ratio of the slurry to be at a desired value only by changing the concentration of the additive.

As a matter of course, it is apparent from the above Fig. 18 through Fig. 20 that the ablating-rate selection ratio can be controlled as desired by appropriately selecting the particle size (dimension) of the abrasive and the concentration of the additive.

A detailed explanation has been so far made for individual embodiments of the present invention. As a matter of course, the present invention may be executed according to in various modifications within the technical scope of the appended claims.

### INDUSTRIAL APPLICABILITY

According to the present invention, an anionic additive is added to a ceria slurry in a certain controlled range, thereby making it possible to improve a polishing-rate selection ratio of an oxide layer in relation to a nitride layer. And the polishing-rate selection ratio of slurry compositions can be controlled as desired by changing a concentration of the additive. Further, according to the present invention, in ceria slurry compositions, the particle size (dimension) of the abrasives is controlled to be in a predetermined range, thereby making it possible to improve the polishing-rate selection ratio of the oxide layer to the nitride layer or to obtain a desired selection ratio within a predetermined range. Therefore, dishing phenomena which affect the oxide layer can be prevented and uniform surface planarization can be attained, thereby resulting in improved reliability of semiconductor devices.

## Claims

1. A chemical-mechanical-polishing slurry composition for polishing and ablating an oxide layer selectively in relation to a nitride layer, the chemical-mechanical-polishing slurry composition comprising ceria polishing particles, a dispersing agent, and an anionic additive,
wherein the anionic additive is added to control a concentration of the anionic additive so that a polishing-rate selection ratio of an oxide layer to a nitride layer is 40 : 1 or greater.

2. A chemical-mechanical-polishing slurry composition according to Claim 1,
wherein a particle size of the ceria polishing particles is controlled to be within a predetermined range.

3. A chemical-mechanical-polishing slurry composition according to Claim 1,
wherein the ceria polishing particles are polycrystalline particles.

4. A chemical-mechanical-polishing slurry composition according to Claim 1,
wherein the anionic additive is water-soluble polyacrylic acid or water-soluble polycarboxylate.

5. A chemical-mechanical-polishing slurry composition according to Claim 1,
wherein a concentration of the anionic additive is from 0.1 to 0.6 wt% in relation to a whole percentage of the slurry composition.

6. A method for planarizing a surface of a semiconductor device comprising:
a step of preparing a semiconductor substrate in which a level difference is formed on a surface thereof and a nitride layer is formed at least on an upper level surface of the level difference;
a step of depositing an oxide layer which is for filling the level difference and planarizing the surface of the semiconductor substrate so that a predetermined thickness of the oxide layer can be added to a surface of the nitride layer; and
a step of ablating the oxide layer by a chemical-mechanical-polishing process so as to expose the surface of the nitride layer,
wherein in the chemical-mechanical-polishing process, a chemical-mechanical-polishing slurry composition is used, and
the chemical-mechanical-polishing slurry composition includes ceria polishing particles, a dispersing agent, and an anionic additive, in which the anionic additive is added to control a concentration of the anionic additive so that a polishing-rate selection ratio of an oxide layer to a nitride layer is 40 : 1 or greater.

7. A method for planarizing a surface of a semiconductor device according to Claim 6,
wherein the level difference is a trench area formed on the surface of the semiconductor substrate.

8. A method for planarizing a surface of a semiconductor device according to Claim 6,
wherein the method further comprises a step of ablating the oxide layer by a chemical-mechanical-polishing process in which a silica slurry is used before the surface of the nitride layer is exposed.

9. A method for planarizing a surface of a semiconductor device according to Claim 6,
wherein the ceria polishing particles are polycrystalline particles.

10. A method for planarizing a surface of a semiconductor device according to Claim 6,
wherein the anionic additive is water-soluble polyacrylic acid or water-soluble polycarboxylate.

11. A method for planarizing a surface of a semiconductor device according to Claim 6,
wherein a concentration of the anionic additive is from 0.1 to 0.6 wt% in relation to a whole percentage of the slurry composition.

12. A method for planarizing a surface of a semiconductor device according to Claim 6,
wherein the oxide layer is a silicon oxide layer, and the nitride layer is a silicon nitride layer.

13. A method for controlling a selection ratio of a chemical-mechanical-polishing slurry composition for polishing and ablating an oxide layer selectively in relation to a nitride layer, the method comprising:
a step of confirming a selection ratio of an oxide layer to a nitride layer of a chemical-mechanical-polishing slurry composition which includes ceria polishing particles, a dispersing agent, and an anionic additive, while a concentration of the anionic additive is changed; and
a step of adjusting the concentration of the anionic additive to attain a desired selection ratio of the slurry composition, on the basis of the confirmed polishing-rate selection ratio, thereby controlling the selection ratio of the slurry composition.

14. A method for controlling a selection ratio of a chemical-mechanical-polishing slurry composition according to Claim 13,
wherein the method further comprises a step of confirming the polishing-rate selection ratio of the oxide layer to the nitride layer, while a particle size of the ceria polishing particles is changed.

15. A method for controlling a selection ratio of a chemical-mechanical-polishing slurry composition according to Claim 13,
wherein the ceria polishing particles are polycrystalline particles.

16. A method for controlling a selection ratio of a chemical-mechanical-polishing slurry composition according to Claim 13,
wherein the anionic additive is water-soluble polyacrylic acid or water-soluble polycarboxylate.

17. A method for controlling a selection ratio of a chemical-mechanical-polishing slurry composition according to Claim 13,
wherein the concentration of the anionic additive is from 0.1 to 0.6 wt% in relation to a whole percentage of the slurry composition.
